# EUROPEAN PATENT APPLICATION

(11) **EP 4 708 590 A1**
(43) Date of publication of application: **11.03.2026**
(21) Application number: 24909470.7
(22) Date of filing: 25.04.2024
(51) Int. Cl.: H01S 5/183

(54) **HIGH-POWER VERTICAL-CAVITY SURFACE-EMITTING LASER AND MANUFACTURING METHOD THEREFOR**

(30) Priority: 27.12.2023 CN 202311826348
(71) Applicant: Vertilite Co., Ltd., Changzhou, Jiangsu 213000 (CN)
(72) Inventor: LIU, Song, hangzhou, Jiangsu 213000 (CN); WENG, Weicheng, hangzhou, Jiangsu 213000 (CN); DING, Weizun, hangzhou, Jiangsu 213000 (CN); TANG, Songling, hangzhou, Jiangsu 213000 (CN); LIANG, Dong, hangzhou, Jiangsu 213000 (CN)
(74) Representative: HGF
(86) International application number: PCT/CN2024/089698
(87) International publication number: WO 2025/138502

(57) **Abstract**

A high-power vertical-cavity surface-emitting laser and a fabrication method thereof are provided. The laser includes: a substrate (10), a semiconductor epitaxial layer (20) located on one side of the substrate (10), a filling layer (30), a dielectric layer (40), and an upper electrode (50). The semiconductor epitaxial layer (20) includes at least one first region E2 and a second region E1 arranged around each first region E2. The semiconductor epitaxial layer (20) in the second region E1 is etched to form a trench (201). The filling layer (30) is filled in the trench (201). The dielectric layer (40) includes a first dielectric layer (41) located on a side of the semiconductor epitaxial layer (20) away from the substrate (10). The dielectric layer (40) includes a first via (401), and a vertical projection of the first via (401) on the semiconductor epitaxial layer (20) is located in a first region E2. The upper electrode (50) is located on a side of the first dielectric layer (41) away from the substrate (10). The upper electrode (50) is electrically connected to the light-emitting structure (24) through the first via (401), and the upper electrode (50) located in the second region E1 is isolated from the filling layer (30) by the first dielectric layer (41).

## Description

This application claims priority to Chinese Patent Application No. 202311826348.1 filed with the China National Intellectual Property Administration (CNIPA) on Dec. 27, 2023, the disclosure of which is incorporated herein by reference in its entirety.

### TECHNICAL FIELD

Embodiments of the present application relate to the field of semiconductor technology, for example, to a high-power vertical-cavity surface-emitting laser and a fabrication method of a high-power vertical-cavity surface-emitting laser.

### BACKGROUND

With the rapid development of modem electronic technology, for example, new energy vehicles, the demand for vertical-cavity surface-emitting lasers (VCSELs) as Lidar (Light Detection and Ranging) light sources has increased significantly.

In Lidar applications, the working conditions are generally narrow pulse drive with a pulse width ranging from 3 ns to 8 ns, and it is precisely because the pulse width is extremely small, the laser can be driven with a larger voltage or current than under DC working conditions. However, a larger voltage or current will bring challenges to the VCSEL. For example, for the VCSELs having trenches with high aspect ratio, the reduction in the spacing between the optical apertures or the increase of the trench etching depth will pose a greater challenge to the trench coverage, affecting the flatness and reliability of the device. Moreover, the capacitance of the laser itself will also affect the performance of narrow pulses.

### SUMMARY

A high-power vertical-cavity surface-emitting laser and a fabrication method thereof are provided according to embodiments of the present application to ensure the flatness of the device while improving the performance and reliability of the device.

According to one aspect of the present application, a high-power vertical-cavity surface-emitting laser is provided, which includes: a substrate, a semiconductor epitaxial layer located on one side of the substrate, a filling layer, a dielectric layer, and an upper electrode. The semiconductor epitaxial layer includes at least one first region and a second region arranged around each first region. The first region has at least one light-emitting structure, and the second region has a trench. The filling layer is filled in the trench. The material of the filling layer has high temperature resistance. The dielectric layer includes a first dielectric layer, and the first dielectric layer is located on a side of the semiconductor epitaxial layer away from the substrate. The dielectric layer includes a first via, and a vertical projection of the first via on the semiconductor epitaxial layer is located in a first region of at least one first region. The upper electrode is located on the side of the first dielectric layer away from the substrate. The upper electrode is electrically connected to a light-emitting structure through the first via, and the upper electrode located in the second region is isolated from the filling layer by the first dielectric layer.

Optionally, the difference between the distance from the substrate to a surface of the filling layer away from the substrate and the distance from the substrate to a surface of the semiconductor epitaxial layer away from the substrate is less than a preset value.

Optionally, the material of the filling layer includes a metal material or a dielectric material.

Optionally, the metal material includes Au or Cu, and the dielectric material includes nitride or oxide.

Optionally, in a direction from the second region to the first region, the width of the trench is less than or equal to 4 µm, and the aspect ratio of the trench is greater than or equal to 2.

Optionally, the trench has an annular shape, and the annular trench is arranged around the light-emitting structure, or the trench is hole-shaped; multiple hole-shaped trenches are arranged around the light-emitting structure.

Optionally, the dielectric layer further includes a second dielectric layer, which is located between the semiconductor epitaxial layer and the first dielectric layer, as well as the sidewall and the bottom of the trench. The dielectric layer includes a first via that extends through both the first dielectric layer and the second dielectric layer, and the upper electrode is electrically connected to the light-emitting structure through the first via.

Optionally, the semiconductor epitaxial layer may include a lower Bragg reflection layer, an upper Bragg reflection layer, and at least one active layer located between the lower Bragg reflection layer and the upper Bragg reflection layer. The lower Bragg reflection layer is closer to the substrate. A part of the active layer located in the first region includes at least one oxide confinement layer for carrier confinement.

According to another aspect of the present application, a fabrication method of a high-power vertical-cavity surface-emitting laser is provided, which includes as following. A substrate is provided. A semiconductor epitaxial layer is formed on one side of the substrate, where the semiconductor epitaxial layer includes at least one first region and a second region arranged around each first region. The semiconductor epitaxial layer in the second region is etched to form a trench, where the semiconductor epitaxial layer located in the first region is used to form a light-emitting structure. A filling layer is formed in the trench. A dielectric layer is formed on a side of the semiconductor epitaxial layer away from the substrate, where the dielectric layer includes a first dielectric layer. The dielectric layer is etched to form a first via in the dielectric layer, where a vertical projection of the first via on the semiconductor epitaxial layer is located in the first region. An upper electrode is formed on a side of the first dielectric layer away from the substrate, where the upper electrode is electrically connected to the light-emitting structure through the first via, and the upper electrode located in the second region is isolated from the filling layer by the first dielectric layer.

Optionally, the material of the filling layer includes a metal material, forming the filling layer in the trench includes: depositing a seed metal and then electroplating Cu or Au to form the filling layer; or the material of the filling layer includes a dielectric material, forming the filling layer in the trench includes: depositing a nitride or oxide in the trench to form the filling layer.

Optionally, before forming the filling layer in the trench, the method further includes forming a dielectric layer between the semiconductor epitaxial layer and the first dielectric layer and on the sidewall and bottom of the trench; where the forming a dielectric layer further includes forming a second dielectric layer between the semiconductor epitaxial layer and the first dielectric layer and on the sidewall and bottom of the trench; and etching the dielectric layer includes etching the first dielectric layer and the second dielectric layer to form the first via extending through the first dielectric layer and the second dielectric layer.

### BRIEF DESCRIPTION OF DRAWINGS

FIG. 1 is a sectional view showing a partial structure of a vertical-cavity surface-emitting laser provided in the related art;
FIG. 2 is a sectional view showing a partial structure of another vertical-cavity surface-emitting laser provided in the related art;
FIG. 3 is a diagram showing a positional relationship between a trench and an optical aperture in a high-power vertical-cavity surface-emitting laser provided in an embodiment of the present application;
FIG. 4 is a diagram showing a positional relationship between a trench and an optical aperture in another high-power vertical-cavity surface-emitting laser provided in an embodiment of the present application;
FIG. 5 is a schematic diagram showing the sectional structure along a section line AA1 in FIG. 3 or along a section line BB 1 in FIG. 4;
FIG. 6 is another schematic diagram showing the sectional structure along a section line AA1 in FIG. 3 or along a section line BB1 in FIG. 4;
FIG. 7 is another schematic diagram showing the sectional structure along a section line AA1 in FIG. 3 or along a section line BB1 in FIG. 4;
FIG. 8 is a flow chart of a fabrication method of a high-power vertical-cavity surface-emitting laser provided in an embodiment of the present application;
FIG. 9 is a flow chart of another fabrication method of a high-power vertical-cavity surface-emitting laser provided in an embodiment of the present application;
FIG. 10 is a structural sectional view of a fabrication method of a high-power vertical-cavity surface-emitting laser provided in an embodiment of the present application at step S210;
FIG. 11 is a structural sectional view of a fabrication method of a high-power vertical-cavity surface-emitting laser provided in an embodiment of the present application at step S230;
FIG. 12 is a structural sectional view of a fabrication method of a high-power vertical-cavity surface-emitting laser provided in an embodiment of the present application at step S230;
FIG. 13 is a structural sectional view of a fabrication method of a high-power vertical-cavity surface-emitting laser provided in an embodiment of the present application at step S240;
FIG. 14 is a structural sectional view of a fabrication method of a high-power vertical-cavity surface-emitting laser provided in an embodiment of the present application at step S250;
FIG. Figure 15 is a structural sectional view of a fabrication method of a high-power vertical-cavity surface-emitting laser provided in an embodiment of the present application at step S260; and
FIG. 16 is a structural sectional view of a fabrication method of a high-power vertical-cavity surface-emitting laser provided in an embodiment of the present application at multiple steps in steps S270 to S280.

### DETAILED DESCRIPTION

The technical solutions in the embodiments of the present application are described hereinafter in conjunction with the drawings in the embodiments of the present application. Obviously, the described embodiments are only part of the embodiments of the present application. Based on the embodiments in the present application, all other embodiments obtained by ordinary skills in the art without making creative efforts should fall within the scope of protection of the present application.

It should be noted that the terms "first", "second", etc., in the specification and claims of the present application and the above-mentioned drawings are intended to distinguish similar objects, and are not necessarily used to describe a specific order or sequence. It should be understood that the data used in this way can be interchanged where appropriate, so that the embodiments of the present application described here can be implemented in an order other than those illustrated or described here. In addition, the terms "including" and "having" and any variations thereof are intended to cover non-exclusive inclusions, for example, a process, method, system, product or apparatus including a series of steps or units is not necessarily limited to include those steps or units explicitly listed, but may include other steps or units not explicitly listed or inherent to such process, method, product or apparatus.

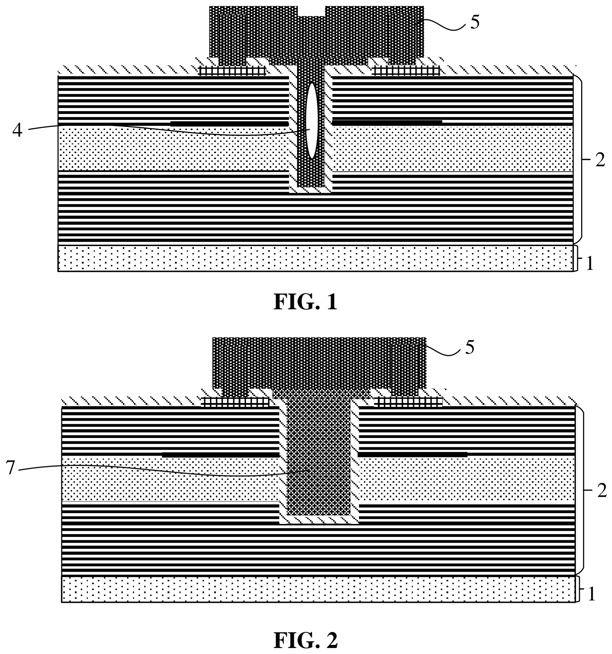

As described in the background art, as the spacing between optical apertures decreases or the etching depth increases, trenches with high aspect ratios become more and more common. FIG. 1 is a sectional view showing a partial structure of a vertical-cavity surface-emitting laser provided in the related art. Referring to FIG. 1, the vertical-cavity surface-emitting laser includes a substrate 1 and a semiconductor epitaxial layer 2 located on one side of the substrate. The semiconductor epitaxial layer 2 includes a lower Bragg reflection layer, an upper Bragg reflection layer, and at least one active layer located between the lower Bragg reflection layer and the upper Bragg reflection layer. The semiconductor epitaxial layer 2 is etched to form a trench in the semiconductor epitaxial layer 2, thereby defining a light-emitting mesa structure. In forming an upper electrode 5 electrically connected to the light-emitting mesa structure, a metal material is deposited in the trench. However, due to the uniformity of the sputtered seed metal and the step coverage of the electroplated Au, the metal deposited in the trench of the upper electrode 5 has a hole 4. After the upper electrode 5 is energized, the metal in the trench is charged and generates heat accordingly. The thermal conductivity of the metal material is higher than the thermal conductivity of the air in the hole 4. The difference in thermal expansion coefficient may reduce the reliability of the laser. Moreover, since the metal in the trench and the lower Bragg reflection layer have opposite polarities and are close to each other, the metal in the trench and the lower Bragg reflection layer will form a larger capacitance; and the larger capacitance may affect the performance of the laser using a short pulse operation mode. In addition, due to the characteristics of the fabrication process, when forming the upper electrode 5, part of the metal will be deposited in the trench. Therefore, the height of the upper electrode 5 located above the trench is less than the height of the upper electrode 5 at the non-trench layer, which affects the flatness of the device and is prone to misjudgment in subsequent visual inspections, affecting the yield.

FIG. 2 is a sectional view showing a partial structure of another vertical-cavity surface-emitting laser provided in the related art. Referring to FIG. 2, in the related art, organic polymers, such as benzo cyclo butene (BCB), polyimide, etc., may also be used to fill the trench to form an organic filling layer 7. However, the cost of raw materials is high, and the reliability of organic polymers will be challenged in high-temperature and high-humidity environments, which will also affect the reliability of the device.

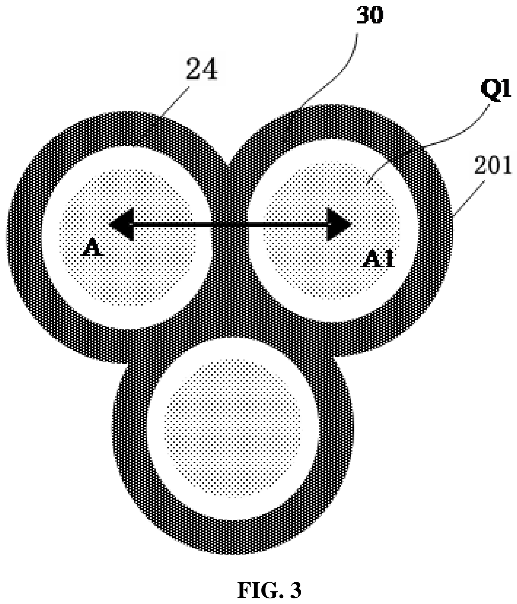

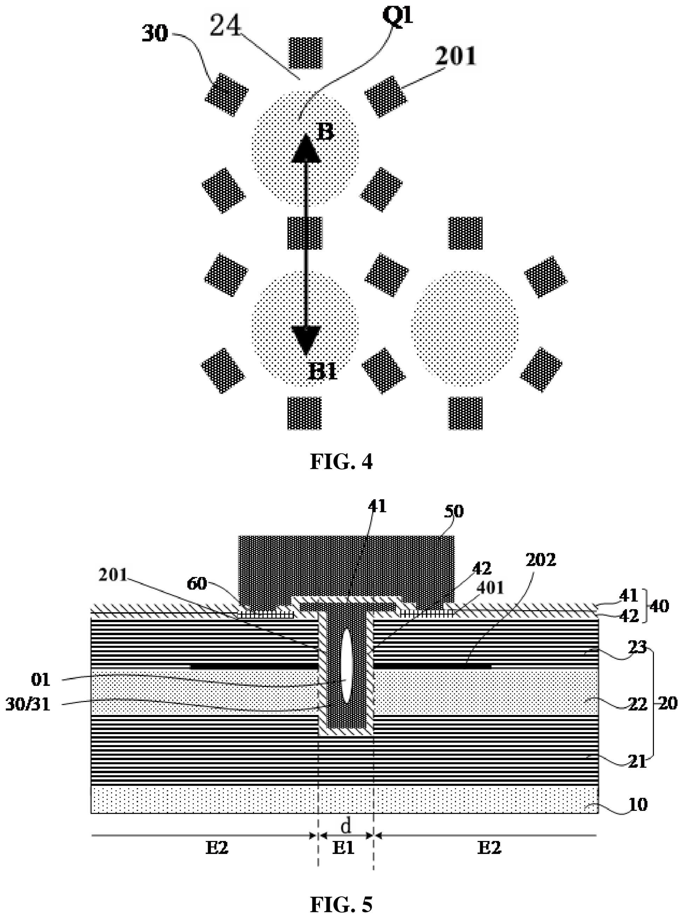

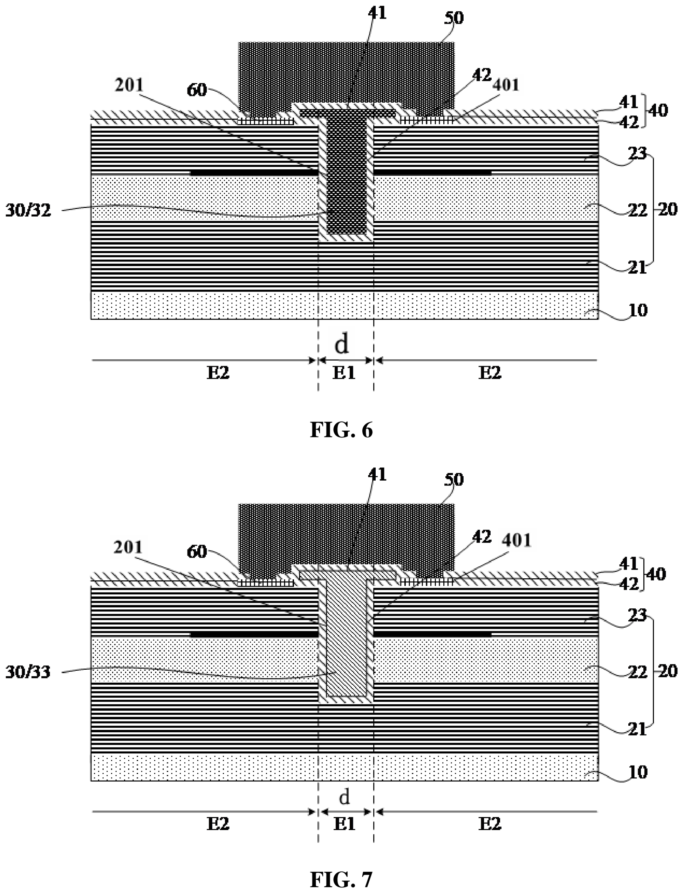

A high-power vertical-cavity surface-emitting laser is provided according to an embodiment of the present application. FIG. 3 is a diagram showing a positional relationship between a trench and an optical aperture in a high-power vertical-cavity surface-emitting laser provided in an embodiment of the present application. FIG. 4 is a diagram showing a positional relationship between a trench and an optical aperture in another high-power vertical-cavity surface-emitting laser provided in an embodiment of the present application. FIG. 5 is a schematic diagram showing the sectional structure along a section line AA1 in FIG. 3 or along a section line BB1 in FIG. 4. FIG. 6 is another schematic diagram showing the sectional structure along a section line AA1 in FIG. 3 or along a section line BB1 in FIG. 4. FIG. 7 is another schematic diagram showing the sectional structure along a section line AA1 in FIG. 3 or along a section line BB1 in FIG. 4. Referring to FIG. 3 to FIG. 7, the high-power vertical-cavity surface-emitting laser includes: a substrate 10, a semiconductor epitaxial layer 20 located on one side of the substrate 10, a filling layer 30, a dielectric layer 40, and an upper electrode 50. The semiconductor epitaxial layer 20 includes at least one first region E2 and a second region E1 arranged around each first region E2. The first region E2 has at least one light-emitting structure 24, and the second region E1 has a trench 201. The filling layer 30 is filled in the trench. The dielectric layer 40 includes a first dielectric layer 41, and the first dielectric layer 41 is located on a side of the semiconductor epitaxial layer 20 away from the substrate 10. The dielectric layer 40 includes a first via 401, and a vertical projection of the first via 401 on the semiconductor epitaxial layer 20 is located in a first region E2. The upper electrode 50 is located on the side of the first dielectric layer 41 away from the substrate 10. The upper electrode 50 is electrically connected to a light-emitting structure 24 through the first via, and the upper electrode 50 located in the second region E1 is isolated from the filling layer 30 by the first dielectric layer 41.

The substrate 10 may be any material suitable for forming a vertical-cavity surface-emitting laser, such as gallium arsenide (GaAs). The substrate 10 may be an N-type doped semiconductor substrate or a P-type doped semiconductor substrate. In some embodiments, if the N ohm metal and the P ohm metal are formed on the same side of the substrate 10, the substrate 10 does not need to act as a conductor to conduct the N ohm metal and the P ohm metal, and the substrate 10 may be a semi-insulating substrate 10. In other embodiments, if the N ohm metal and the P ohm metal are formed on opposite sides of the substrate 10, the substrate 10 needs to act as a conductor to conduct the N ohm metal and the P ohm metal, and the substrate 10 is a conductive substrate 10. In FIG. 5 to FIG. 7, in this embodiment, the substrate 10 is an N-type doped semiconductor substrate, the P ohm metal 60 is located on the side of the semiconductor epitaxial layer 20 away from the substrate, and the upper electrode 50 is in contact with the P ohm metal 60 through the first via 401, thereby achieving electrical connection of the upper electrode 50 with the light-emitting structure 24.

The semiconductor epitaxial layer 20 may include a lower Bragg reflection layer 21, an upper Bragg reflection layer 23, and at least one active layer 22 located between the lower Bragg reflection layer 21 and the upper Bragg reflection layer 23. The lower Bragg reflection layer 21 is closer to the substrate 10. The lower Bragg reflection layer 21, the upper Bragg reflection layer 23, and the active layer 22 may be formed by chemical vapor deposition. The lower Bragg reflection layer 21 may be formed by stacking material layers with two different refractive indices, namely, aluminum gallium arsenide material layers and gallium arsenide material layers, or by stacking material layers with two different refractive indices, namely, aluminum gallium arsenide material layers with high aluminum content and aluminum gallium arsenide material layers with low aluminum content. The active layer 22 is composed of GaAs and AlGaAs, or InGaAs and AlGaAs materials stacked and arranged, and the active layer 22 is used to convert electrical energy into light energy. When the active layer 22 is of multiple layers, a tunnel junction is provided between two adjacent active layers 22, and the layers are connected in series by tunnel junctions. The upper Bragg reflection layer 23 can be formed by stacking material layers with two different refractive indices, namely, AlGaAs material layers and GaAs material layers, or by stacking material layers with two different refractive indices, namely, AlGaAs material layers with high aluminum content and AlGaAs material layers with low aluminum content. The upper Bragg reflection layer 23 and the lower Bragg reflection layer 21 are used to enhance by reflecting the light generated by the active layer 22 in the middle, and then emit it from the surface of the upper Bragg reflection layer 23 to form a laser.

In some embodiments, the lower Bragg reflection layer 21 and the upper Bragg reflection layer 23 may also be formed by other materials. The lower Bragg reflection layer 21 and the upper Bragg reflection layer 23 include a series of alternating layers of materials with different refractive indices, the effective optical thickness of each alternating layer (the thickness of the layer multiplied by the refractive index of the layer) is an odd integer multiple of one quarter of the operating wavelength of the vertical-cavity surface-emitting laser, that is, the effective optical thickness of each alternating layer is one quarter of the odd integer multiple of the operating wavelength of the vertical-cavity surface-emitting laser.

The semiconductor epitaxial layer 20 includes at least one first region E2 and a second region E1 arranged around each first region E2. The semiconductor epitaxial layer 20 of the first region E2 is configured to form a light-emitting structure 24, and the semiconductor epitaxial layer 20 of the second region E1 is provided with a trench 201. It can be understood that the semiconductor epitaxial structure located in the second region E1 is etched by dry etching to form the trench 201, thereby forming a light-emitting structure in the first region E2. After the light-emitting structure 24 is formed, an oxide confinement layer 202 is formed in the light-emitting structure 24. The oxide confinement layer 202 has an aperture, and the aperture is configured to define an optical aperture Q1 of the light-emitting structure 24. In this embodiment, the oxide confinement layer 202 in each light-emitting structure 24 is an annular structure. In a case where the top view of the light-emitting structure 24 is rectangular, the oxide confinement layer 202 may also be a rectangular ring. Optionally, the semiconductor epitaxial layer 20 located in the first region E2 is configured to form a single light-emitting structure 24, and may also be configured to form a light-emitting structure array. A filling layer 30 is provided in the trench 201, and the trench 201 is filled by the filling layer 30, so that the side of the semiconductor epitaxial layer 20 away from the substrate 10 has a relatively flat surface. On this basis, the upper electrode 50 is formed on the side of the first dielectric layer 41 away from the substrate 10, and the surfaces of the first dielectric layer 41 and the upper electrode 50 are flatter. Thus, it can mitigate the issue of poor device flatness caused by the reduction of the spacing between the optical apertures and the increase of the etching depth of the trench 201 in the VCSEL with high aspect ratio trenches. The first dielectric layer 41 has a first via 401 in the first region E2, so that the upper electrode 50 can be electrically connected to the light-emitting structure 24 located in the first region E2 through the first via 401, and while injecting current into the light-emitting structure 24, the upper electrode 50 is isolated from the filling layer 30 located in the second region E1. Therefore, the material of the filling layer 30 can be a dielectric material or a material with high thermal conductivity, such as a metal material. The material of the filling layer 30 is a material with high temperature resistance and low cost, so as to achieve flatness while ensuring the reliability of the laser at high temperatures.

By isolating the upper electrode 50 from the filling layer 30 in the trench 201 through the first dielectric layer 41, it is possible to prevent, when the filling layer 30 in the trench 201 is made of a metal material, the metal in the trench 201 from being charged and generating heat due to contact with the upper electrode 50, thereby mitigating the issue of the formation of a hole 01 in the metal within the trench 201 due to the poor step coverage of the metal material within the trench 201, and the issues caused by the difference between thermal conductivities and between thermal expansion coefficients of the metal and the air in the hole; thereby improving the reliability of the device. Additionally, it is possible to prevent a large capacitance from forming, as the metal in the trench 201 and the lower Bragg reflection layer 21 have opposite polarities and are close to each other; thereby avoiding the effect on the performance of the laser when operating in a short pulse mode.

Based on the above multiple embodiments, with reference to FIG. 5, in one embodiment of the present application, the metal material of the filling layer 30 includes Au, so that an Au filling layer 31 is formed.

Due to the uniformity of the sputtered seed metal and the step coverage of the electroplated Au, the metal in the trench 201 forms a hole 01. The upper electrode 50 is isolated from the filling layer 30 in the trench 201 by the first dielectric layer 41, which can prevent the metal in the trench 201 from being charged and generating heat due to contact with the upper electrode 50, thereby eliminating the issue of forming a hole 01 in the metal in the trench 201 due to the poor step coverage of the metal material in the trench 201, and the issues caused by difference between thermal conductivities and between thermal expansion coefficients of the metal and the air in the hole 01, thereby improving the reliability of the device. In addition, it is also possible to prevent the formation of a large capacitance due to the opposite polarities, close distance of the metal in the trench 201 and the lower Bragg reflection layer 21, which may affect the performance of the laser adopting a short pulse operation mode.

Based on the above multiple embodiments, referring to FIG. 6, in another embodiment of the present application, the metal material of the filling layer 30 includes Cu, so that a Cu filling layer 32 is formed. Cu has better hole filling performance than Au and has lower costs.

Based on the above multiple embodiments, referring to FIG. 7, in another embodiment of the present application, the filling layer 30 is a dielectric material, so that a dielectric filling layer 33 is formed. The dielectric material includes nitride or oxide.

Covering both the surface of the trench 201 and the surface of the semiconductor epitaxial layer 20 with a dielectric film can achieve an insulating effect. The filling layer 30, made of a nitride or oxide, can be formed by some techniques with good step coverage. Exemplarily, the nitride includes silicon nitride (SiN), and SiN can be deposited by a plasma-enhanced chemical vapor deposition (PECVD) device using a tetraethyl orthosilicate (TEOS) source, or by a high-density plasma chemical vapor deposition (HDPCVD) device. The oxide includes silicon dioxide (SiO₂), and SiO₂ can be deposited by a plasma-enhanced atomic layer deposition (PE-ALD) device. By forming nitride or oxide through some techniques with good step coverage, a filling layer 30 without the hole 01 can be formed, thereby avoiding the influence of the hole 01 in the filling layer 30 on the reliability of the device.

In a case where the filling material in the trench 201 is a metal material, the dielectric layer 40 of the high-power vertical-cavity surface-emitting laser further includes a second dielectric layer 42. The second dielectric layer 42 is located between the semiconductor epitaxial layer 20 and the first dielectric layer 41, as well as the sidewall and the bottom of the trench 201. The dielectric layer 40 includes the first via 401, the first via 401 extends through both the first dielectric layer 41 and the second dielectric layer 42, and a vertical projection of the first via 401 on the semiconductor epitaxial layer 20 is located in a first region E2. The upper electrode 50 is electrically connected to the light-emitting structure 24 through the first via 401. By providing the second dielectric layer 42 in the high-power vertical-cavity surface-emitting laser, it is possible to prevent the metal layer in the trench 201 from directly connecting the upper Bragg reflection layer 23 and the lower Bragg reflection layer 21, thereby preventing the high-power vertical-cavity surface-emitting laser from short-circuiting which may affect the normal light emission of the active layer 22 located between the upper Bragg reflection layer 23 and the lower Bragg reflection layer 21. In a case where the filling material in the trench 201 is a dielectric material, the second dielectric layer 42 may be provided between the semiconductor epitaxial layer 20 and the first dielectric layer 41 and on the sidewall and bottom of the trench 201, or may not be provided.

Based on the above-described multiple embodiments, in one embodiment of the present application, the difference between the distance between the substrate 10 and the surface of the filling layer 30 away from the substrate 10 and the distance between the substrate 10 and the surface of the semiconductor epitaxial layer 20 away from the substrate 10 is less than a preset value. Optionally, the distance between the substrate 10 and the surface of the filling layer 30 away from the substrate 10 is equal to the distance between the substrate 10 and the surface of the semiconductor epitaxial layer 20 away from the substrate 10, which can further improve the flatness of the laser.

Based on the above multiple embodiments, in one embodiment of the present application, the width d of the trench is less than or equal to 4 µm, and the aspect ratio of the trench is greater than or equal to 3.

Setting the width d of the trench 201 to be less than or equal to 4 µm enables the spacing between the light-emitting structures 24 to be smaller, thereby increasing the number of light-emitting structures 24 per unit area in the high-power vertical-cavity surface-emitting laser and improving the light output of the high-power vertical-cavity surface-emitting laser. Setting the aspect ratio of the trench to be greater than or equal to 2 enables the depth of the trench to be larger, thereby increasing the number of active layers 22 included in the light-emitting structure 24, then increasing the light output of a single light-emitting structure 24, and further improving the light output of the high-power vertical-cavity surface-emitting laser.

Based on the above multiple embodiments, with reference to FIG. 3, in an embodiment of the present application, the trench 201 has an annular shape, and the annular trench 201 is arranged around the light-emitting structure 24. In another embodiment of the present application, with reference to FIG. 4, the trench 201 is hole-shaped; multiple hole-shaped trenches 201 are arranged around the light-emitting structure 24. The shape of the trench 201 can be set according to practical requirements.

Optionally, an ion implantation layer is provided on a side of the trench 201 close to the light-emitting structure 24, and the ion implantation layer is configured to isolate the filling layer 30 from the light-emitting structure 24.

It can be understood that due to the characteristics of the fabrication process of the second dielectric layer 42, the thickness of the second dielectric layer 42 on the sidewall of the trench 201 gradually decreases in a direction from the upper electrode 50 to the lower Bragg reflection layer 21. In a case where the depth of the trench 201 is large, the thickness of the second dielectric layer 42 at a portion of the sidewall close to the bottom of the trench is too small, or even no second dielectric layer 42 is formed there, which increases the risk of short circuit of the device. By providing an ion implantation layer on the side of the trench 201 close to the light-emitting structure 24, the electrical insulation between the filling layer 30 and the light-emitting structure 24 can be further enhanced.

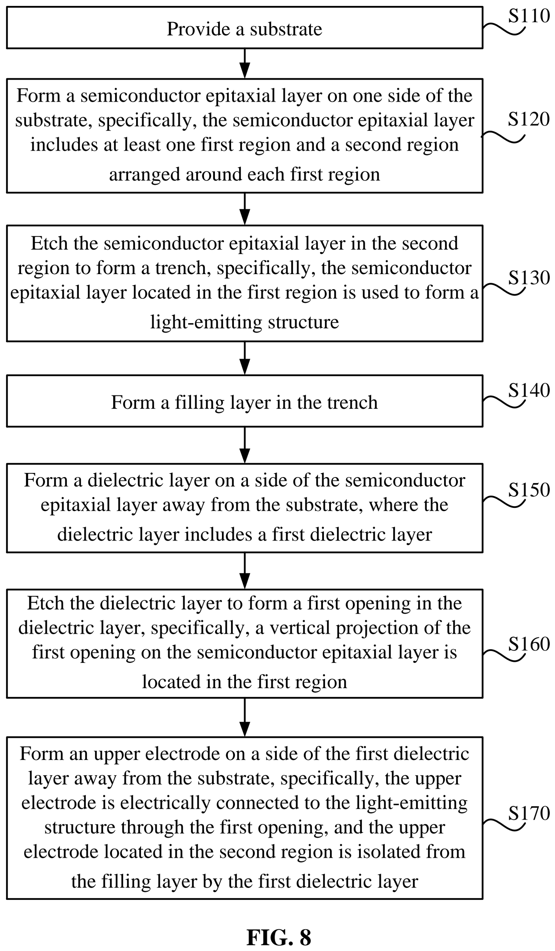

A fabrication method of a high-power vertical-cavity surface-emitting laser is further provided according to the present application, which is used to prepare the high-power vertical-cavity surface-emitting laser described in any of the above embodiments. FIG. 8 is a flow chart of a fabrication method of a high-power vertical-cavity surface-emitting laser provided in embodiments of the present application. Referring to FIG. 8, the fabrication method of a high-power vertical-cavity surface-emitting laser includes the following steps S110 to S170.

In S110, a substrate is provided.

In S120, a semiconductor epitaxial layer is formed on one side of the substrate. The semiconductor epitaxial layer includes at least one first region and a second region arranged around each first region.

In S130, the semiconductor epitaxial layer in the second region is etched to form a trench. Specifically, the semiconductor epitaxial layer located in the first region is used to form a light-emitting structure.

In S140, a filling layer is formed in the trench.

A filling layer is arranged in the trench, the trench is filled with the filling layer, thereby mitigating the issue of poor device flatness caused by the reduction of the spacing between the optical apertures and the increase of the etching depth of the trench in the VCSEL with high aspect ratio trenches.

In S150, a dielectric layer is formed on a side of the semiconductor epitaxial layer away from the substrate, where the dielectric layer includes a first dielectric layer.

In S160, the dielectric layer is etched to form a first via in the dielectric layer, and a vertical projection of the first via on the semiconductor epitaxial layer is located in the first region.

In S170, an upper electrode is formed on a side of the first dielectric layer away from the substrate; the upper electrode is electrically connected to the light-emitting structure through the first via, and the upper electrode in the second region is isolated from the filling layer by the first dielectric layer.

The upper electrode is arranged on the side of the first dielectric layer away from the substrate. The dielectric layer has a first via in the first region, so that the upper electrode can contact the light-emitting structure in the first region through the first via, inject current into the light-emitting structure, and be isolated from the filling layer in the second region. By separating the upper electrode from the filling layer in the trench by the first dielectric layer, it is possible to prevent, when the filling layer in the trench is made of metal material, the metal in the trench from contacting the upper electrode to be charged and generate heat, thereby eliminating the issue of forming a hole in the metal in the trench due to poor step coverage of the metal material in the trench and causing temperature cycling, and thus improving the reliability of the device. In addition, it is also possible to prevent the large capacitance from being formed since the metal in the trench and the lower Bragg reflection layer have opposite polarities and are close to each other, which may adversely affect the performance of the laser adopting a short pulse operation mode.

With the fabrication method of a high-power vertical-cavity surface-emitting laser provided in the embodiments of the present application, the flatness of the device can be improved by setting the filling layer in the trench; furthermore, the upper electrode is isolated from the filling layer in the trench by the first dielectric layer, compared with the related art in which part of the metal material forming the upper electrode is formed in the trench, the present application can prevent the metal in the trench from contacting the upper electrode to be charged and generate heat, thereby eliminating the issue of forming a hole in the metal in the trench due to poor step coverage of the metal material in the trench and causing temperature cycling, and thus improving the reliability of the device. Additionally, it is possible to prevent a large capacitance from forming, as the metal in the trench and the lower Bragg reflection layer have opposite polarities and are close to each other, which may adversely affect the performance of the laser when operating in a short pulse mode.

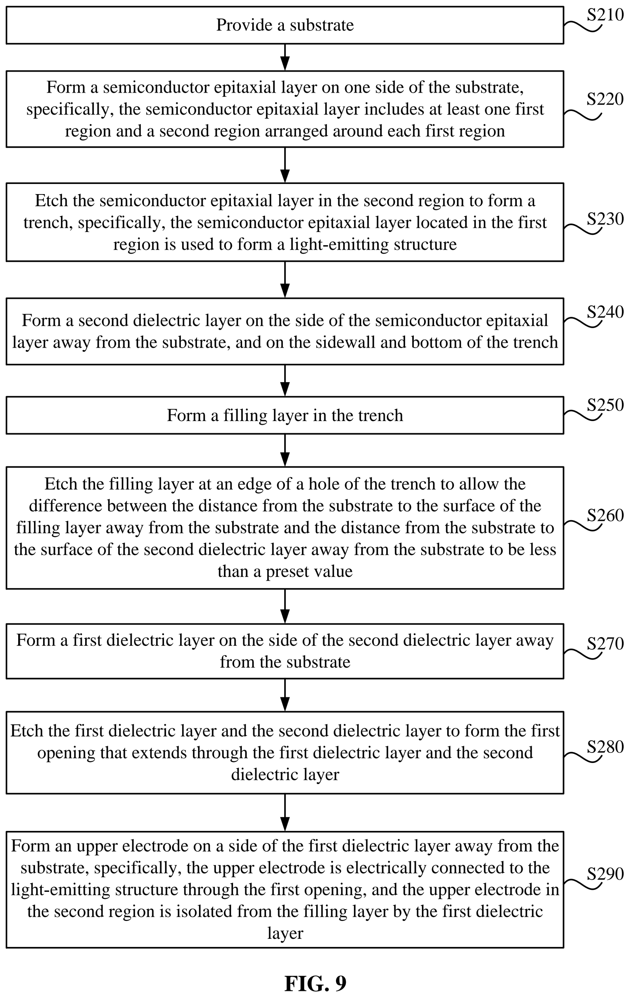

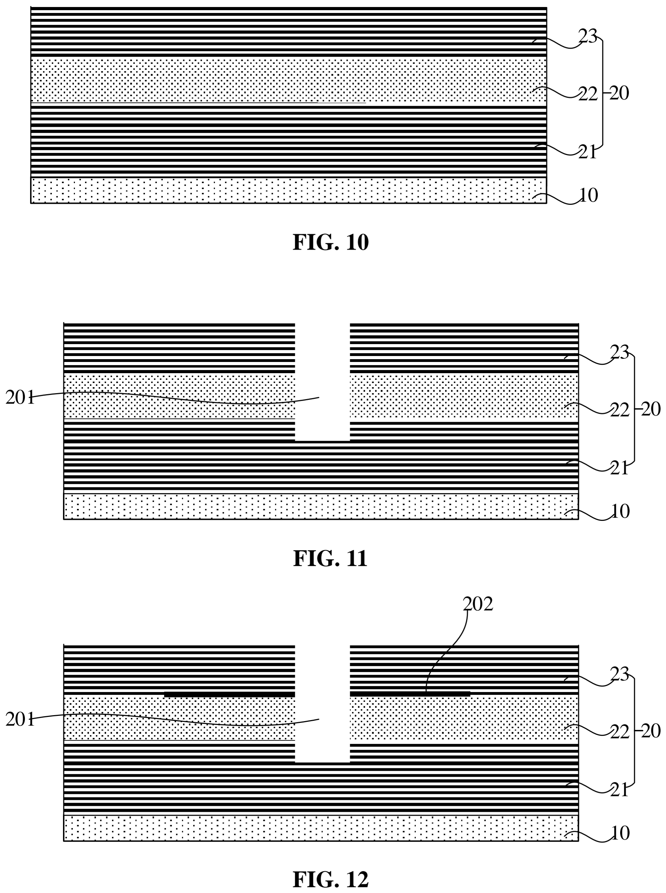

FIG. 9 is a flow chart of another fabrication method of a high-power vertical-cavity surface-emitting laser provided in an embodiment of the present application; FIGS. 10 to 16 are structural sectional views showing the fabrication method of a high-power vertical-cavity surface-emitting laser provided in an embodiment of the present application at steps S210 to S280. Referring to FIG. 9 to FIG. 16, the fabrication method of a high-power vertical-cavity surface-emitting laser includes the following steps S210 to S290.

In S210, a substrate is provided.

Referring to FIG. 10, the substrate 10 may be any material suitable for forming the vertical-cavity surface-emitting laser, such as gallium arsenide (GaAs). The substrate 10 may be an N-type doped semiconductor substrate or a P-type doped semiconductor substrate 10. In this embodiment, the substrate 10 is an N-type doped semiconductor substrate 10. In some embodiments, the substrate 10 may be a semi-insulating substrate 10. In other embodiments, the substrate 10 may be a conductive substrate 10.

In S220, a semiconductor epitaxial layer is formed on one side of the substrate; the semiconductor epitaxial layer includes at least one first region and a second region arranged around each first region.

Continuing to refer to FIG. 10, forming a semiconductor epitaxial layer 20 on one side of the substrate 10 includes sequentially forming a lower Bragg reflection layer 21, at least one active layer 22, and an upper Bragg reflector 23. The lower Bragg reflection layer 21 and the upper Bragg reflector 23 can each be formed by stacking material layers with two different refractive indices, namely, aluminum gallium arsenide material layers and gallium arsenide material layers, or by stacking material layers with two different refractive indices, namely, aluminum gallium arsenide material layers with high aluminum content and aluminum gallium arsenide material layers with low aluminum content. The active layer 22 is composed of GaAs and AlGaAs, or InGaAs and AlGaAs material layers stacked and arranged, and the active layer 22 is configured to convert electrical energy into light energy. When the active layer 22 is a multilayer, a tunnel junction is provided between two adjacent active layers 22, and the two adjacent active layers 22 are connected by the tunnel junction. In some embodiments, the lower Bragg reflection layer 21 and the upper Bragg reflector 23 may also be formed of other materials. The lower Bragg reflection layer 21 and the upper Bragg reflection layer 23 include a series of alternating layers of materials with different refractive indices, the effective optical thickness of each alternating layer (the thickness of the layer multiplied by the refractive index of the layer) is an odd integer multiple of one quarter of the operating wavelength of the vertical-cavity surface-emitting laser, that is, the effective optical thickness of each alternating layer is one quarter of the odd integer multiple of the operating wavelength of the vertical-cavity surface-emitting laser.

In S230, the semiconductor epitaxial layer in the second region is etched to form a trench, where the semiconductor epitaxial layer located in the first region is used to form a light-emitting structure.

Referring to FIG. 11, the semiconductor epitaxial layer 20 located in the second region is etched by dry etching to form a trench 201, thereby forming a light-emitting mesa structure in the first region. The bottom of the trench 201 is etched at least to the lower Bragg reflection layer 21.

Referring to FIG. 12, after the light-emitting structure 24 is formed in the first region, an oxide confinement layer 202 is formed in the light-emitting structure 24. The oxide confinement layer 202 has an aperture, and the aperture is configured to define an optical aperture Q1 of the light-emitting structure 24. In this embodiment, the sidewall of the trench is oxidized by wet oxidation of highly doped aluminum under certain temperature conditions to form an oxide confinement layer 202 in the upper Bragg reflector 23. The lengths of the oxide confinement layers 202 on two sides of the trench 201 are equal. The aluminum oxide formed after oxidation has a high impedance. The opening position of the oxide confinement layer 202 is still a highly aluminum-doped aluminum gallium arsenic material. When the current enters the light-emitting mesa structure, the current will flow to the active layer 22 through the opening in the oxide confinement layer 202. In this embodiment, the oxide confinement layer 202 in each light-emitting structure 24 is an annular structure. In a case where the top view of the light-emitting structure 24 is rectangular, the oxide confinement layer 202 may also be a rectangular ring.

In S240, a second dielectric layer is formed on a side of the semiconductor epitaxial layer away from the substrate and on the sidewall and bottom of the trench.

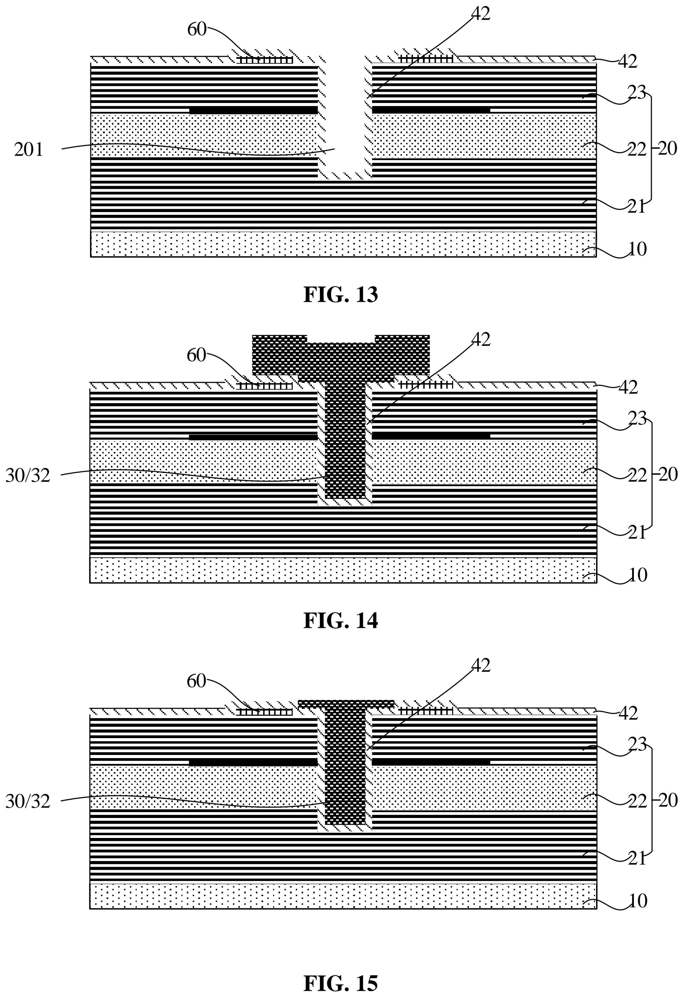

Referring to FIG. 13, before the second dielectric layer 42 is formed, the method further includes: forming an ohmic layer 60 on the surface of the semiconductor epitaxial layer 20 in the first region.

In S250, a filling layer is formed in the trench.

Referring to FIG. 14, the filling layer 30 formed in the trench may be a dielectric layer, or may be a material with high thermal conductivity, such as a metal material. The metal material may be, for example, Cu or Au. FIG. 14 exemplarily shows the filling layer 30 as a Cu filling layer 32. In a case where Au is used as the material of the filling layer, the Cu filling layer 32 in FIG. 14 is replaced by an Au filling layer.

In S260, the filling layer at an edge of a hole of the trench is etched to allow the difference between the distance from the substrate to the surface of the filling layer away from the substrate and the distance from the substrate to the surface of the second dielectric layer away from the substrate to be less than a preset value.

Referring to FIG. 15, the filling layer 30 at the edge of the hole of the trench is etched so that the difference between the distance from the substrate 10 to the surface of the filling layer 30 away from the substrate 10 and the distance from the substrate 10 to the surface of the second dielectric layer 42 away from the substrate 10 is less than a preset value. In order to improve the device density, after the metal material is electroplated, etching is used to etch away the Au/Cu that exceeds the trench, and only the hole-filling part is retained as much as possible to avoid adversely affecting the spacing of other structures. In a case where the filling layer 30 is a dielectric material, the dielectric material that exceeds the trench may also be etched away, and only the hole-filling part is retained as much as possible.

S270, a first dielectric layer is formed on the side of the second dielectric layer away from the substrate.

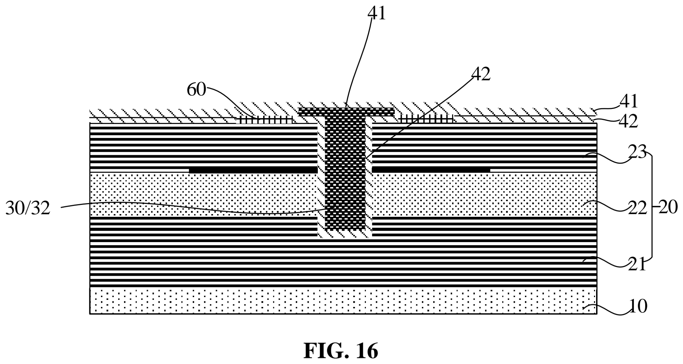

Referring to FIG. 16, a first dielectric layer 41 is formed on the side of the second dielectric layer 42 away from the substrate 10. The material of the second dielectric layer 42 is the same as or different from that of the first dielectric layer 41. In addition, when the material of the filling layer 30 is a dielectric material, the materials of the three can be the same or different.

S280, the first dielectric layer and the second dielectric layer are etched to form the first via that extends through the first dielectric layer and the second dielectric layer.

A vertical projection of the first via 401 on the semiconductor epitaxial layer is located in the first region.

In S290, an upper electrode is formed on a side of the first dielectric layer away from the substrate; the upper electrode is electrically connected to the light-emitting structure through the first via, and the upper electrode in the second region is isolated from the filling layer by the first dielectric layer. (Reference may be made to FIG. 6)

When the material of the filling layer 30 includes a metal material, forming the filling layer 30 in the trench includes: depositing a seed metal and then electroplating Cu or Au to form the filling layer 30. When the material of the filling layer 30 includes a dielectric material, forming the filling layer 30 in the trench includes: depositing a nitride or oxide in the trench to form the filling layer 30. If electroplating gold is used for hole filling, titanium tungsten (TiW) can be deposited by the physical vapor deposition (PVD) process as the seed metal. If the filling metal is Cu, for example, titanium nitride (TiN) or Ru, can be deposited by ALD or PVD process as the seed layer metal.

In a case where the filling material in the trench is a metal material, a second dielectric layer 42 is required to be provided in the high-power vertical-cavity surface-emitting laser to prevent the metal layer in the trench from directly connecting the upper Bragg reflection layer 23 and the lower Bragg reflection layer 21, thereby preventing the high-power vertical-cavity surface-emitting laser from short-circuiting which may adversely affect the normal light emission of the active layer 22. In a case where the filling material in the trench is a dielectric material, the second dielectric layer 42 may be provided between the semiconductor epitaxial layer 20 and the first dielectric layer 41 and on the sidewall and bottom of the trench, or may not be provided.

The method for preparing the high-power vertical-cavity surface-emitting laser described in any of the above embodiments is part of the device processing flow, which mainly reflects the technical solution of the present application, and other procedures or processes known in the art required for manufacturing the device are omitted.

## Claims

1. A high-power vertical-cavity surface-emitting laser, comprising:
a substrate;
a semiconductor epitaxial layer, located on one side of the substrate; wherein the semiconductor epitaxial layer comprises at least one first region and a second region arranged around each first region, each first region has at least one light-emitting structure, and the second region has a trench;
a filling layer, filled in the trench;
a dielectric layer, wherein the dielectric layer comprises a first dielectric layer located on a side of the semiconductor epitaxial layer away from the substrate; and the dielectric layer comprises a first via, and a vertical projection of the first via on the semiconductor epitaxial layer is located in a first region of the at least one first region; and
an upper electrode, located on a side of the first dielectric layer away from the substrate, wherein the upper electrode is electrically connected to a light-emitting structure through the first via, and the upper electrode located in the second region is isolated from the filling layer by the first dielectric layer.

2. The high-power vertical-cavity surface-emitting laser according to claim 1, wherein a difference between a distance from the substrate to a surface of the filling layer away from the substrate and a distance from the substrate to a surface of the semiconductor epitaxial layer away from the substrate is less than a preset value.

3. The high-power vertical-cavity surface-emitting laser according to claim 1, wherein a material of the filling layer comprises a metal material or a dielectric material.

4. The high-power vertical-cavity surface-emitting laser according to claim 3, wherein the metal material comprises Au or Cu, and the dielectric material comprises nitride or oxide.

5. The high-power vertical-cavity surface-emitting laser according to claim 1, wherein,
the trench has a width less than or equal to 4 µm; and
the trench has an aspect ratio greater than or equal to 2.

6. The high-power vertical-cavity surface-emitting laser according to claim 1, wherein,
the trench has an annular shape, and the annular trench is arranged around the light-emitting structure;
or the trench is hole-shaped, and a plurality of hole-shaped trenches are arranged around the light-emitting structure.

7. The high-power vertical-cavity surface-emitting laser according to claim 3, wherein the dielectric layer further comprises:
a second dielectric layer, located between the semiconductor epitaxial layer and the first dielectric layer, as well as a sidewall and a bottom of the trench,
wherein the dielectric layer comprises a first via, the first via extends through both the first dielectric layer and the second dielectric layer, and the upper electrode is electrically connected to the light-emitting structure through the first via.

8. The high-power vertical-cavity surface-emitting laser according to claim 1, wherein,
the semiconductor epitaxial layer comprises a lower Bragg reflection layer, an upper Bragg reflection layer, and at least one active layer located between the lower Bragg reflection layer and the upper Bragg reflection layer, wherein the lower Bragg reflection layer is closer to the substrate; and
an active layer located in the first region comprises at least one oxide confinement layer for carrier confinement.

9. A fabrication method of a high-power vertical-cavity surface-emitting laser, comprising:
providing a substrate;
forming a semiconductor epitaxial layer on one side of the substrate, wherein the semiconductor epitaxial layer comprises at least one first region and a second region arranged around each first region;
etching the semiconductor epitaxial layer in the second region to form a trench, wherein the semiconductor epitaxial layer located in the first region is configured to form a light-emitting structure;
forming a filling layer in the trench;
forming a dielectric layer on a side of the semiconductor epitaxial layer away from the substrate, wherein the dielectric layer comprises a first dielectric layer;
etching the dielectric layer to form a first via in the dielectric layer, wherein a vertical projection of the first via on the semiconductor epitaxial layer is located in the first region; and
forming an upper electrode on a side of the first dielectric layer away from the substrate, wherein the upper electrode is electrically connected to the light-emitting structure through the first via, and the upper electrode located in the second region is isolated from the filling layer by the first dielectric layer.

10. The fabrication method of the high-power vertical-cavity surface-emitting laser according to claim 9, wherein a material of the filling layer comprises a metal material, and the forming the filling layer in the trench comprises:
depositing a seed metal and then electroplating Cu or Au to form the filling layer;
or a material of the filling layer comprises a dielectric material, and the forming a filling layer in the trench comprises:
depositing a nitride or oxide in the trench to form the filling layer.

11. The fabrication method of the high-power vertical-cavity surface-emitting laser according to claim 9, before forming a filling layer in the trench, further comprising:
forming a dielectric layer between the semiconductor epitaxial layer and the first dielectric layer and on a sidewall and a bottom of the trench; wherein the forming a dielectric layer further comprises forming a second dielectric layer, the second dielectric layer is located between the semiconductor epitaxial layer and the first dielectric layer and on the sidewall and the bottom of the trench; and
etching the dielectric layer comprises:
etching the first dielectric layer and the second dielectric layer to form the first via extending through the first dielectric layer and the second dielectric layer.
